(19) Europäisches Patentamt
European Patent Office
Office européen des brevets

(11) **EP 1 819 052 A1**

(12) **EUROPEAN PATENT APPLICATION**

(43) Date of publication:
**15.08.2007 Bulletin 2007/33**

(51) Int Cl.:
*H03M 5/08* (2006.01)     *H03F 3/217* (2006.01)

(21) Application number: **06002585.5**

(22) Date of filing: **08.02.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(71) Applicant: **Infineon Technologies AG
81669 München (DE)**

(72) Inventor: **Lewis, Michael
195 52 Maersta (SE)**

(74) Representative: **Schoppe, Fritz et al
Patentanwälte
Schoppe, Zimmermann, Stöckeler & Zinkler
P.O. Box 246
82043 Pullach bei München (DE)**

(54) **Method for use in pulse-width modulation, and pulse-width modulator**

(57) The invention relates to a method for generating an estimate of a switching instant in pulse-width modulation, wherein the switching instant corresponds to a point where the amplitude of a carrier signal $S_c$ becomes greater than the amplitude of a input signal $S_{in}$. The method comprises the steps of: generating an estimate of a switching instant $t_{lin}$ based on the two consecutive: samples $S_n$, $S_{n+1}$ of the input signal $S_{in}$; generating an estimate of the input signal amplitude at or near the estimated switching instant $t_{lin}$; and generating an updated estimate, $t_{est}$ of the switching instant based on the input signal amplitude at or near the estimated switching instant $t_{lin}$ and either the earlier one $S_n$ or the later one $S_{n+1}$ of the samples of the input signal $S_{in}$. An efficient algorithm is thereby provided, requiring fewer computations than an over-sampling method. The invention also relates to a pulse-width modulator comprising means for performing the algorithm.

## FIG 5

## Description

## Field of the invention

The invention relates generally to pulse-width modulation, and in particular to a method for generating a switching instant in pulse-width modulation, as defined in the preamble of claim 1, and to a pulse-width modulator as defined in the preamble of claim 10.

## Background of the invention

There are several techniques to convert an analog signal to a digital signal and vice versa. Pulse Width Modulation (PWM) refers to a method of carrying information on a train of pulses, the information being encoded in the width of the pulses.

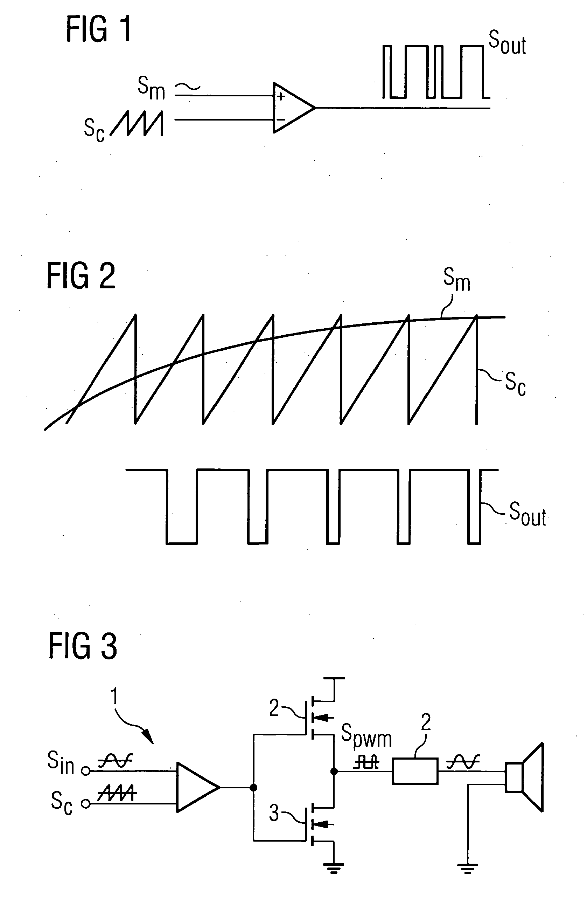

A simple way of generating pulse width modulation, and shown schematically in figure 1, is to compare an analog signal $S_m$, for example representing speech, to a reference signal or carrier signal $S_c$ having a simple, linear slope waveform, such as a triangular waveform or saw tooth waveform. The output signal $S_{out}$, i.e. the pulse-width modulated signal, goes high when the analog signal $S_m$ is higher than the carrier signal $S_c$, as is schematically shown in figure 2.

A new class of audio amplifiers, called "class-D" amplifiers, is based on the pulse-width modulation principle and they are becoming increasingly popular. In class-D amplifiers the output transistors are operated as switches. The output is driven by a pulse train with a frequency substantially greater than the highest frequency of interest in the signal and the duty cycle of the pulses, i.e. the time that the signal is high, are varied such that the wanted signal can be recreated by passing the output through a low-pass filter. Such an amplifier is an attractive choice for low-power, low-cost systems since it offers very high efficiency and compact output transistors.

Figure 3 illustrates such an analog class-D amplifier 1. The pulse train $S_{PWM}$ is generated by comparing the input signal $S_{in}$ with the high-frequency sawtooth shaped carrier signal $S_c$, as was described above. When the carrier signal $S_c$ has lower amplitude than the input signal $S_{in}$, the output switching transistors 2, 3 drive a high signal, and when the carrier signal $S_c$ has higher amplitude than the input signal $S_{in}$, the output switching transistors 2, 3 drive a low signal. The low-pass filter 4 eliminates the carrier signal $S_c$ components at the output, leaving only the desired signal.

This prior art method of generating a pulse-width modulated signal is known as "natural sampling". It can be shown that this pulse-width modulated signal will, if the output switch is ideal, generate an output signal with no harmonic distortion. This is shown in the publication by B. Gwee, J.S Chang, H. Li, "A Micropower Low-Distortion Digital Pulsewidth Modulator for a Digital Class D Amplifier", IEEE Transactions on Circuits and Systems II: Analog and Digital Signal Processing, vol. 49, nr. 4, April 2002, pp. 245-256.

The analog class-D amplifier illustrated in figure 3 is a continuous-time system, i.e. all signals are defined at all points in time. However, in many cases it is required to generate an analog output from a digitized signal. In this case, the digitized signal is only defined at discrete points in time, the sampling points, with the interval between these points being defined by the sampling frequency. Nyquist sampling theorem states that a digitized signal can be perfectly recreated at all points in time as long as the sampling frequency is greater than twice the highest signal frequency.

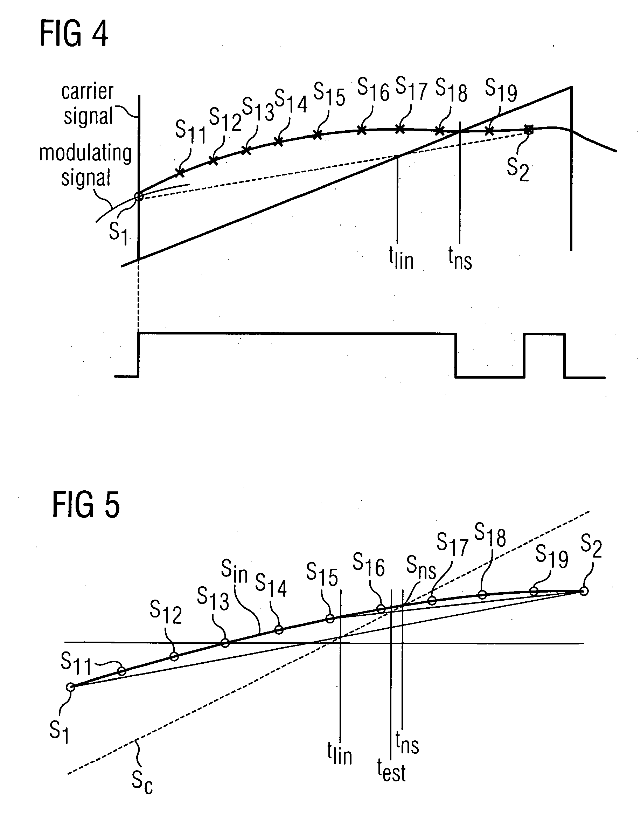

In the natural sampling process the point in time where the carrier waveform becomes greater than the signal waveform is found, as illustrated in figure 4, by the instant $t_{ns}$. However, the dicrete-time nature of the digitized signal makes it problematic to find the ideal switching instant that would be given by the natural sampling method. The digitized signal may well be accurately known in amplitude, for example an audio signal represented with a precision of 16 bits. However, in order to avoid distortion in the output signal it is necessary to translate this into a signal with similarly precise timing accuracy. If the digitized signal in figure 4 is known at samples $S_1$ and $S_2$, then the ideal switching instant $t_{ns}$ may be far from these points in time.

One approach for achieving the necessary timing accuracy is to oversample the digital signal. In this case the sampling rate is increased by an interpolation filter so as to generate more digitized points $S_{11}$,..., $S_{19}$ along the waveform, thereby generating data points closer in time to the optimum switching point. However, to accurately generate all of the intermediate data points requires a significant processing effort, which is time-consuming and requires more complex circuitry and thereby increased chip area.

Another approach to achieving the necessary timing accuracy is to use some simpler form of interpolation to estimate the crossing point of the carrier, e.g. linear interpolation or approximate linear ($\delta C$) interpolation, as described in the earlier referenced publication. However, as can be seen in figure 4, the estimate $t_{lin}$ so generated still deviates significantly from the optimal sampling instant $t_{ns}$ and significantly more than would be the case with the oversampling shown.

In practice, linear interpolation may be combined with the use of oversampling in order to keep the degree of oversampling to an acceptable level.

It would thus be desirable to provide an improved trade-off between the number of computations required for estimating an optimal sampling instant and the accuracy of the estimate.

## Summary of the invention

An object of the invention is to provide an improved timing resolution in pulse-width modulation without increasing the processing effort required to obtain an acceptable estimation and thereby at least alleviating the shortcomings of the prior art.

This object, among others, is achieved by a method for generating an estimate of a switching instant in pulse-width modulation in accordance with claim 1 and by a pulse-width modulator in accordance with claim 10.

In accordance with the invention a method is provided for generating an estimate of a switching instant in pulse-width modulation, wherein the switching instant corresponds to a point where the amplitude of a carrier signal $S_c$ becomes greater than the amplitude of an input signal $S_{in}$. The method comprises the steps of generating an estimate of a switching instant $t_{lin}$ based on two consecutive samples $S_n$, $S_{n+1}$ of the input signal $S_{in}$; calculating a value of the input signal amplitude at or near the estimated switching instant $t_{lin}$; and generating an updated estimate $t_{est}$ of the switching instant based on the input signal amplitude at or near the estimated switching instant $t_{lin}$ and either $S_{n+1}$ or $S_n$ of the samples of the input signal $S_{in}$. The accuracy achieved after a single iteration of the present invention is substantially better than would be obtained by using over-sampling and also better than would be obtained by linear interpolation alone. It can further be seen that subsequent iterations of the algorithm quickly converge on the optimum sampling point. The invention thus provides an efficient algorithm for determining the switching point. In the method a fewer number of calculations is needed compared to an over-sampling method, and an increased accuracy is obtained compared to a linear interpolation method. Circuitry needed for implementing the algorithm has little complexity, is rather inexpensive and has low power consumption.

In accordance with an embodiment of the invention the step of generating an estimate of a switching instant $t_{lin}$ is based on a linear interpolation or an approximate linear interpolation between the samples $S_n$, $S_{n+1}$ of the input signal $S_{in}$. A linear or approximate linear interpolation requires a favourable small computational effort, but is yet adequate for the present invention. Also the step of generating an updated, more accurate, estimate of a switching instant $t_{est}$ can be based on a linear interpolation or an approximate linear interpolation.

In accordance with an embodiment of the invention the steps of the methods are repeated using the updated switching point and related sample point. The steps may for example be repeated until a desired accuracy is reached or a predetermined number of times. The obtained accuracy may thus be varied, for example in accordance with the accuracy required in a desired application, providing a flexible method.

In accordance with an embodiment of the invention generation of an estimate of the input signal amplitude at or near the estimated switching instant $t_{lin}$ is performed by using a polyphase finite impulse response filter structure, or by using a fractional delay filter. The method can thus be implemented using different solutions, and a designer of a modulator circuit implementing the method is thus provided with different choices of circuitry.

The present invention also relates to a pulse-width modulator comprising means for performing the above method, whereby advantages corresponding to the above are obtained. In particular, the timing resolution of a pulse-width modulator is greatly improved without an increased hardware cost.

## Brief description of the drawings

Figure 1 schematically illustrates a pulse-width modulator.

Figure 2 illustrates the principle of pulse-width modulation.

Figure 3 illustrates an analog class-D amplifier.

Figure 4 is a graph for illustrating a natural sampling method and an over-sampling method.

Figure 5 is a graph illustrating a digital approximation to the natural sampling process.

Figure 6 is an illustration of the method in accordance with the invention.

Figure 7 is a flow chart over the method in accordance with the present invention.

## Detailed description of preferred embodiments

In accordance with the invention a method is provided that achieves a timing resolution equal to the combined over-sampling and linear interpolation process described in the introductory part, but with a greatly reduced processing effort. In the inventive method the calculation of unnecessary data points, i.e. not used data points, is substantially reduced.

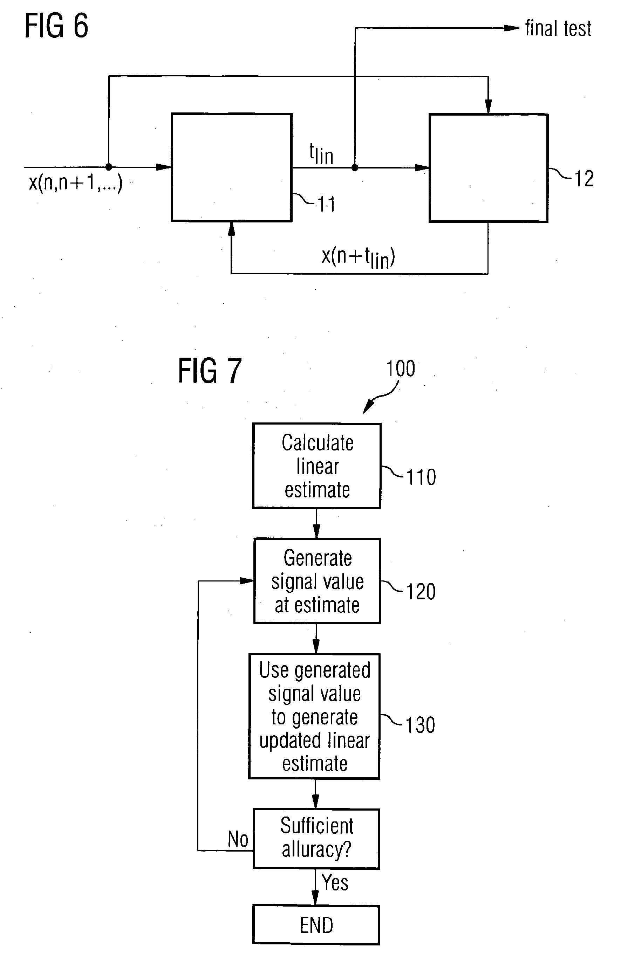

In figure 5 the dotted line, indicated by $S_c$, illustrates the reference signal or carrier signal used; the unbroken line illustrates the input signal, indicated by $S_{in}$. As described above, in the output pulse-width modulated signal $S_{PWM}$ the "on-time" or the time when the signal is high represents the amplitude of the analog input signal $S_{in}$. For performing this switching between high and low states, a pulse width modulator usually comprises a comparator that compares the input signal $S_{in}$ with the carrier signal $S_c$. At the instant in time $t_{ns}$ when the amplitude of the carrier signal $S_c$ becomes higher than the input signal $S_{in}$ a switching is performed. This instant in time $t_{ns}$, i.e. the crossing point where the carrier amplitude becomes higher than the input signal amplitude, is called the switching point. The importance of obtaining an accurate measure of the pulse-width is readily understood, and this in turn requires an accurate switching point to be determined. The carrier signal $S_c$ is a linear slope waveform, preferably a saw tooth waveform. However, it is conceivable to use another linear slope waveform, such as a triangular waveform. Further, it is realised that the carrier signal used should have a frequency greater than the highest frequency of interest in the input signal $S_{in}$.

In accordance with the present method, the switching point is determined by an iterative process. Two consecutive sampling points $S_1$ and $S_2$ are used as the starting points for the method. It is realised that a linear estimation $t_{lin}$ for the switching point can be obtained by using simple trigonometry; This is described in the earlier mentioned reference.

Now, having the linear estimation $t_{lin}$, an estimate of the signal amplitude is next generated at or near this estimated instant $t_{lin}$. This signal amplitude estimate can, for example, be generated by a polyphase FIR (finite impulse response) filter structure, which can generate a desired one of a number of evenly spaced data points $S_{11},...,S_{19}$. In this case, it can be seen that the point $S_{15}$ is closest to the signal amplitude at $t_{lin}$, and therefore only the polyphase corresponding to $S_{15}$ would need to be calculated. Alternatively, a generalized fractional delay filter could be used to generate a data point representing the amplitude of the input signal $S_{in}$ even closer to $t_{lin}$. It is realised that any of a wide range of interpolation/resampling methods can be used for calculating the signal amplitude at the estimated instant $t_{lin}$.

The signal amplitude at or near $t_{lin}$ has thus been determined. In the illustrated case a value $S_{15}$ is obtained as the signal amplitude near $t_{lin}$. The calculated value $S_{15}$ and either $S_1$ or $S_2$ are next used as the starting points for obtaining an updated and improved estimate of the crossing point $t_{est}$. Whether to use $S_1$ or $S_2$ depends on whether the value $S_{15}$ is greater or less than the carrier amplitude at that point, i.e. whether the crossing point $t_{est}$ is to the right or to the left of the optimal switching point $t_{ns}$. It is realised that the value $S_x$ most recently calculated is used in subsequent iterations, i.e. $S_{15}$ replaces $S_1$ in this case, and in a following iteration $S_{15}$ could be replaced with a more recent value.

If the accuracy of the estimated crossing point $t_{est}$ is satisfactory, the method for calculating the switching point is completed. If the accuracy is not high enough, the amplitude of the signal at or near the crossing point $t_{est}$ is determined. In the illustrated case, the signal amplitude $S_{16}$ would be used as an estimate of the amplitude at $t_{est}$. The points $S_{16}$ and $S_2$ would thereafter be used as the starting points for obtaining a further yet improved estimate of the crossing point, and another linear estimate of the crossing point would be determined, $t_{lin}^2$. In this particular example it can be seen that the second calculated estimation for the crossing point $t_{lin}^2$ would lie very close to the first estimation $t_{est}$ and does therefore not improve the accuracy very much.

In the described example only points $S_1$, $S_2$ and $S_{15}$ need to be calculated in order to obtain a fairly good accuracy, which is a substantial improvement compared to the over-sampling method, which would require all points $S_{11}, S_{12},..., S_{19}$ to be calculated. The accuracy of the inventive method is greatly improved compared to the simple linear sampling method, which would yield $t_{lin}$ as the switching point whereas the inventive method would yield a switching point $t_{est}$ closer to the actual switching point $t_{ns}$, and still at a low computational cost.

Figure 6 is an illustration of the method in accordance with the invention. Samples $S(n)$, $S(n+1)$ are input to blocks 11 and 12. In block 11 a linear estimate of the crossing point $t_{lin}$ between the carrier signal and the linear interpolation of the input samples is generated. This value $t_{lin}$ is input to block 12, which, for example, is a fractional delay filter calculating a signal amplitude value close to $t_{lin}$. In block 12 updated samples $S(t_{lin})$, $S(n+1)/S(n)$ are generated and input to block 11. This is repeated until a desired accuracy has been reached, and a final switching point is taken as input $t_{est}^{final}$ to the switches switching between a high state (i.e. a logic "1") and a low state (i.e. a logic "0"). In an alternative embodiment the number of iterations is set to a predetermined value.

Figure 7 is another illustration of the method in the form of a flow chart over the steps included in the method. The method 100 starts with the calculation of an estimate of the crossing point based on two input samples of the input signal. This is done in a first step, step 110, and preferably makes use of a simple method, which in this context means a method requiring as little computational effort as possible, such as linear interpolation or approximate linear interpolation.

The generated estimate of the switching instance $t_{lin}$ is then used, in step 120, in order to calculate a value $S_x$ of the amplitude of the input signal at or near that instance $t_{lin}$.

Next, in step 130, the calculated signal value $S_x$ is used in order to generate an updated linear estimate $t_{est}$. A simple method such as approximate linear interpolation is again used in order to calculate this updated estimate of the signal crossing point $t_{est}$.

Next, in step 140 it is determined whether the accuracy is sufficient or not. The determination whether the accuracy is sufficient can for example be done by comparing the difference between two consecutive estimated values, and when the difference is small enough the accuracy is determined to be good enough. If yes, the method ends, else steps 120 and 130 are repeated using the updated sample points and signal amplitude values. The steps 120 and 130 can be repeated an arbitrary number of times. The number of repetitions is dependent on the required accuracy.

It can be understood that the accuracy achieved after a single iteration of the presented algorithm is substantially better than would be attained by either one of the approaches of over-sampling or linear interpolation alone, given the same computational complexity. It can further be shown that subsequent iterations of the algorithm would quickly converge on the optimum sampling point.

In another aspect of the invention, a pulse width modulator is provided. The pulse-width modulator comprises means for performing the above-described efficient algorithm, and is suitable for use in, for example, high fidelity audio applications.

The modulator comprises means for generating an estimate of a switching instant $t_{lin}$ preferably based on a linear interpolation or an approximate linear interpolation between two consecutive samples $S_n$, $S_{n+1}$ of the input signal $S_{in}$.

Further, the modulator comprises means for calculating an estimate of the input signal amplitude at or near the estimated switching instant $t_{lin}$. This means could, for example be a polyphase finite impulse response filter structure or a fractional delay filter.

Further yet, the modulator comprises means for generating an updated estimate of the switching point $t_{est}$ based on a linear interpolation or an approximate linear interpolation between the estimated input signal amplitude at the estimated switching instant $t_{lin}$ and one of the samples $S_n$, $S_{n+1}$ of the input signal $S_{in}$.

In summary, the invention provides an efficient algorithm for determining the switching point. In the method a fewer number of calculations is needed compared to an over-sampling method, and an increased accuracy is obtained compared to a linear interpolation method. The circuitry needed for implementing the algorithm has little complexity, is rather inexpensive and has low power consumption.

## Claims

1.  A method for generating an updated estimate of a switching instant in pulse-width modulation, said switching instant corresponding to a point where the amplitude of a carrier signal $S_c$ becomes greater than the amplitude of a input signal $S_{in}$, **characterised in** the steps of:

    - generating an estimate of a switching instant $t_{lin}$ based on two consecutive samples $S_n$, $S_{n+1}$ of the input signal $S_{in}$,
    - calculating an estimate of the input signal amplitude at or near the estimated switching instant $t_{lin}$, and
    - generating said updated estimate $t_{est}$ of the switching instant based on the calculated estimate of the input signal amplitude at the estimated switching instant $t_{lin}$ and either one of said

two consecutive samples $S_n$ or $S_{n+1}$.

2.  The method as claimed in claim 1, wherein said step of generating an estimate of a switching instant $t_{lin}$ is based on a linear interpolation or an approximate linear interpolation between said samples $S_n$, $S_{n+1}$ of the input signal $S_{in}$.

3.  The method as claimed in claim 1 or 2, wherein said step of generating an estimate of a switching instant $t_{lin}$ is based on a linear interpolation or an approximate linear interpolation between the input signal amplitude at the estimated switching instant $t_{lin}$ and either the earlier one $S_n$ or the later one $S_{n+1}$ of the samples of the input signal $S_{in}$.

4.  The method as claimed in any of the preceding claims, wherein the step of calculating an estimate of the input signal amplitude is repeated using the updated estimate of the switching instant $t_{est}$ and the step of generating an updated estimate of the switching instant is repeated based on the estimated input signal amplitude at or near the estimated switching instant $t_{est}$ and one of the other known samples of the input signal $S_{in}$.

5.  The method as claimed in claim 4, wherein said steps are repeated until a desired accuracy is reached.

6.  The method as claimed in claim 1, wherein the step of calculating an estimate of the input signal amplitude at or near the estimated switching instant $t_{lin}$ is performed by using a polyphase finite impulse response filter structure.

7.  The method as claimed in claim 1, wherein the step of calculating an estimate of the input signal amplitude at the estimated switching instant $t_{lin}$ is performed utilising a fractional delay filter.

8.  The method as claimed in any of the preceding claims, wherein the carrier signal $S_c$ is a linear slope waveform.

9.  The method as claimed in claim 6, wherein the linear slope waveform is a saw tooth waveform.

10. A pulse width modulator, **characterised in that** it comprises:

    - means for generating an estimate of a switching instant $t_{lin}$ based on two consecutive samples $S_n$, $S_{n+1}$ of the input signal $S_{in}$,
    - means for calculating an estimate of the input signal amplitude at or near the estimated switching instant $t_{lin}$, and
    - means for generating an updated estimate $t_{est}$ of the switching instant based on the input signal amplitude at or near the estimated switching instant $t_{lin}$ and either the earlier one $S_n$ or the later one $S_{n+1}$ of the samples of the input signal $S_{in}$.

11. The pulse width modulator as claimed in claim 10, wherein said means for calculating an estimate of the input signal amplitude at or near the estimated switching instant $t_{lin}$ is a polyphase finite impulse response filter structure.

12. The pulse width modulator as claimed in claim 10, wherein said means for calculating an estimate of the input signal amplitude at or near the estimated switching instant $t_{lin}$ is a fractional delay filter.

## FIG 1

$S_m \sim$

$S_c$

$S_{out}$

## FIG 2

$S_m$

$S_c$

$S_{out}$

## FIG 3

1

$S_{in}$

$S_c$

2

$S_{pwm}$

2

3

## FIG 4

carrier signal

modulating signal

$S_{11}$ $S_{12}$ $S_{13}$ $S_{14}$ $S_{15}$ $S_{16}$ $S_{17}$ $S_{18}$ $S_{19}$

$S_1$

$S_2$

$t_{lin}$ $t_{ns}$

## FIG 5

$S_{12}$ $S_{13}$ $S_{in}$ $S_{14}$ $S_{15}$ $S_{16}$ $S_{ns}$ $S_{17}$ $S_{18}$ $S_{19}$ $S_2$

$S_{11}$

$S_1$

$S_c$

$t_{lin}$ $t_{est}$ $t_{ns}$

## FIG 6

x(n,n+1,...)

$t_{lin}$

final test

~11

~12

$x(n+t_{lin})$

## FIG 7

100

Calculate
linear
estimate ~110

Generate
signal value
at estimate ~120

Use generated
signal value
to generate ~130
updated linear
estimate

Sufficient
alluracy?

No

Yes

END

European Patent Office

**EUROPEAN SEARCH REPORT**

Application Number

EP 06 00 2585

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | GUINEE R ET AL: "A novel single Fourier series technique for the simulation and analysis of asynchronous pulse width modulation" PROCEEDINGS OF THE THIRTEENTH ANNUAL APPLIED POWER ELECTRONICS CONFERENCE AND EXPOSITION 1998 (APEC '98), ANAHEIM, CA, USA, 15-19 FEBRUARY 1998, vol. 1, 15 February 1998 (1998-02-15), pages 123-128, XP010263585 IEEE ISBN: 0-7803-4340-9 | 1-5,8-10 | INV. H03M5/08 H03F3/217 |
| Y | * section II.C, lines 1 to 19; figure 2 * | 6,7,11, 12 | |
| A | SCHWARZ H R: "Numerische Mathematik" 1986, B.G. TEUBNER , STUTTGART, GERMANY , XP002411888 * page 198 - page 199; figure 5.1 * | 1-5,10 | |
| Y | MIDYA P ET AL: "Prediction correction algorithm for natural pulse width modulation" PROCEEDINGS OF THE 109TH AES CONVENTION, 22-25 SEPTEMBER 2000, LOS ANGELES, CALIFORNIA, USA, 22 September 2000 (2000-09-22), pages 1-24, XP009008487 Audio Engineering Society * section 3; figure 4 * | 6,7,11, 12 | TECHNICAL FIELDS SEARCHED (IPC) H03M H03F H03K |

-/--

The present search report has been drawn up for all claims

| Place of search | Date of completion of the search | Examiner |
|---|---|---|
| Berlin | 18 December 2006 | DOMINGO VECCHIONI, M |

EPO FORM 1503 03.82 (P04C01)

European Patent
Office

**EUROPEAN SEARCH REPORT**

Application Number

EP 06 00 2585

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | LAAKSO T I ET AL: "Splitting the unit delay - Tools for fractional delay filter design" IEEE SIGNAL PROCESSING MAGAZINE, vol. 13, no. 1, January 1996 (1996-01), pages 30-60, XP002050526 IEEE ISSN: 1053-587X * page 41, box "Design Guide 1" * | 7,12 | |
| X | GOLDBERG J M ET AL: "New high accuracy pulse width modulation based digital-to-analogue convertor/power amplifier" IEE PROCEEDINGS: CIRCUITS, DEVICES AND SYSTEMS, vol. 141, no. 4, August 1994 (1994-08), pages 315-324, XP006001521 Institution of Electrical Engineers, Stenvenage, GB * section 4 * | 1,2,4,5, 8-10 | |
| A | GWEE B-H ET AL: "A micropower low-distortion digital class-D amplifier based on an algorithmic pulsewidth modulator" IEEE TRANSACTIONS ON CIRCUITS AND SYSTEMS I: REGULAR PAPERS, vol. 52, no. 10, October 2005 (2005-10), pages 2007-2022, XP011140994 IEEE ISSN: 1057-7122 * page 2009, right-hand column, "section II.A" - page 2011, left-hand column, fourth paragraph * | | TECHNICAL FIELDS SEARCHED (IPC) |

The present search report has been drawn up for all claims

| Place of search | Date of completion of the search | Examiner |
|---|---|---|
| Berlin | 18 December 2006 | DOMINGO VECCHIONI, M |

EPO FORM 1503 03.82 (P04C01)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

• **B. GWEE ; J.S CHANG ; H. LI.** A Micropower Low-Distortion Digital Pulsewidth Modulator for a Digital Class D Amplifier. *IEEE Transactions on Circuits and Systems II: Analog and Digital Signal Processing,* April 2002, vol. 49 (4), 245-256